Europäisches Patentamt

European Patent Office

Office européen des brevets

(11) Veröffentlichungsnummer: **0 262 371**
**A2**

(12) **EUROPÄISCHE PATENTANMELDUNG**

(21) Anmeldenummer: 87112046.5

(51) Int. Cl.⁴ **G01R 1/073**

(22) Anmeldetag: 19.08.87

(30) Priorität: 29.08.86 DE 3629407
16.07.87 DE 3723570

(43) Veröffentlichungstag der Anmeldung:
06.04.88 Patentblatt 88/14

(84) Benannte Vertragsstaaten:
AT BE CH DE FR GB IT LI NL

(71) Anmelder: **Siemens Aktiengesellschaft Berlin und München**
**Wittelsbacherplatz 2**
**D-8000 München 2(DE)**

(72) Erfinder: **Seinecke, Siegfried, Dipl.-Ing.**
**Kiem-Pauli-Weg 3**
**D-8130 Starnberg 2(DE)**

(54) **Kontaktiervorrichtung in Form einer sogenannten Nadelkarte für zu prüfende hochpolige Bauelemente der Mikroelektronik.**

(57) Kontaktiervorrichtung in Form einer sogenannten Nadelkarte für zu prüfende hochpolige Bauelemente der Mikroelektronik

Die Kontaktiernadeln (2) sind U-förmig ausgestaltet und so angeordnet, daß jeweils der eine der beiden Schenkel (3) der Nadeln (2) durch ein engtoleriertes Führungsloch (4) in der Nadelkarte (1) senkrecht nach unten ragt und seine Spitze federnd auf den Kontaktfleck (5) des zu prüfenden Bauelements (6) drückt, daß der jeweils andere Schenkel (7) der Nadeln (2) mit den Zuleitungen (8) zur Prüfeinrichtung verbunden ist und daß der die beiden Schenkel verbindende Teil (9) der Nadeln (2) geradlinig ausgestaltet und in engem Abstand zu der Nadelkarte (1) angeordnet ist.

FIG 1

EP 0 262 371 A2

## Kontaktiervorrichtung in Form einer sogenannten Nadelkarte für zu prüfende hochpolige Bauelemente der Mikroelektronik.

Die Erfindung bezieht sich auf eine Kontaktiervorrichtung für zu prüfende hochpolige Bauelemente der Mikroelektronik, insbesondere hochintegrierte Schaltkreise, in Form einer sogenannten Nadelkarte mit einer der Anzahl der Kontakte des zur prüfenden Bauelements entsprechenden Anzahl von Kontaktiernadeln.

Moderne Bauelemente der Mikroelektronik, wie z.B. hochintegrierte Schaltungen als Chip auf einer Siliziumscheibe, müssen in Prüfeinrichtungen so kontaktiert werden, daß die Kontaktiervorrichtung selbst möglichst nur geringe elektrische Störgrößen (wie z.B. Serieninduktivitäten, Erdkapazitäten und elektromagnetische Kopplungen, sowie ohmsche Kontaktwiderstände) erzeugt. Nur dann können die elektrischen Eigenschaften des Bauteils einwandfrei gemessen werden. Fehlerfreie Messungen an Subnanosekundenschaltkreisen und -Chips sind aber aus folgenden Gründen mit herkömmlichen Kontaktiervorrichtungen nur schwer oder gar nicht durchzuführen: Die hochintegrierten Bauelemente erhalten zunehmend immer feinere Kontaktteilungen. Eine Kontaktierung durch die bisher übliche Ausgestaltung und Abmessung von Einzelfedern hat somit konstruktive Grenzen und erzeugt elektrische Störungen. Eine Kontaktierung durch Verwendung von flexiblen gedruckten Schaltungen in Verbindung mit einem elastischen Andruckkissen führt nicht unbedingt zu gleichmäßigen Kontaktkräften für alle Kontakte. Sie stößt aber auch noch aus einem anderen Grunde auf Schwierigkeiten. Wenn die Zahl der Kontakte des zu prüfenden Bauelementes so groß ist, daß sie nicht mehr alle in einer einzigen Reihe am Rande des Bauelementes angeordnet werden können, ist es bislang nicht möglich, flexible gedruckte Schaltungen einzusetzen, die mit den in mehreren Reihen hintereinander angeordneten Kontaktflecken der Bauelemente kontaktiert werden könnten. Die Chipkontaktierung auf Scheiben erfolgt deshalb heute noch mit Abtastnadeln.

Für die Ausbildung solcher Kontaktiervorrichtungen mit Abtastnadeln, die in einer der Anzahl der Kontakte des zu prüfenden Bauelements entsprechenden Anzahl in einer sogenannten Nadelkarte angeordnet sind, sind eine Reihe von Lösungen bekannt geworden. So ist es z.B. bekannt, vom Rande der inneren Öffnung der Nadelkarte weg schräg nach unten frei wegragende Kontaktiernadeln vorzusehen, die jeweils mit einem nach unten weggebogenen freien Ende auf den jeweiligen Kontaktflecken des Bauelementes drücken. Die Herstellung derartiger Kontaktvorrichtung ist bei Kontaktiervorrichtung für die Prüfung sehr hochpoliger Bauelemente wegen der geringen Abstände der Kontaktflecken der Bauelemente und ihrer somit extrem geringen Abmessungen äußerst schwierig.

Es ist daher auch schon vorgeschlagen worden, die der Kontaktierung dienenden Enden der Kontaktnadeln in Führungslöchern einer Platte zu führen, die über dem zu prüfenden Bauelement angeordnet wird. Die Nadeln ragen von dieser Platte nach oben hin leicht gebogen weg und sind an ihrem Ende in einen gemeinsamen Block eingebettet. Durch die leichte Durchbiegung der Nadeln können diese beim Andruck auf das jeweils zu prüfende Bauele ment etwas seitlich ausweichen und damit einen federnden Andruck ermöglichen. Der Nachteil dieser Anordnung ist, daß die Kontaktierungsnadeln nicht in Richtung der Nadelkarte sondern senkrecht zu ihr nach oben wegführen und damit wegen ihrer Länge und Lage große elektrische Störgrößen erzeugen. Ferner ist ein Auswechseln einzelner Nadeln im Fall ihrer Beschädigung bei dieser Kontaktiervorrichtung überhaupt nicht möglich.

Es ist auch schon vorgeschlagen worden, die einzelnen Kontaktiernadeln in dünnen Röhrchen zu führen, die alle miteinander in einem sogenannten Kontaktblock eingegossen sind und damit ihre Abstände sicher halten. Der Nachteil dieser Kontaktiervorrichtungen ist, daß der Querschnitt der Nadeln bei sehr geringem Abstand der Kontakte des zu prüfenden Bauelementes stark verringert werden muß, da sie ja auch noch in den Führungsröhrchen geführt sind. Ferner ist die Kontaktgabe zwischen Nadel und Führungsrohr unsicher. Da alle Führungsröhrchen in dem Kontaktblock vergossen sind, ist zwar das Auswechseln einzelner Nadeln, nicht aber das Auswechseln beschädigter Führungsröhrchen möglich.

Der Erfindung liegt daher die Aufgabe zugrunde, eine Kontaktiervorrichtung der eingangs genannten Art zu schaffen, die aber im Gegensatz zu den bekannten Kontaktiervorrichtungen keine großen elektrischen Störgrößen erzeugt, mit hoher Präzision und weitgehend mechanisiert hergestellt werden kann, und bei der einzelne Kontaktiernadeln oder Gruppen von Nadeln jederzeit ausgewechselt werden können.

Erfindungsgemäß wird dies dadurch erreicht, daß die Kontaktiernadeln U-förmig ausgestaltet und so angeordnet sind, daß jeweils der eine der beiden Schenkel der Nadeln durch ein engtoleriertes Führungsloch in der Nadelkarte senkrecht nach unten ragt und seine Spitze federnd auf den Kontaktfleck des zu prüfenden Bauelements drückt, daß der jeweils andere Schenkel der Nadeln mit den Zuleitungen zur Prüfeinrichtung verbunden ist und daß der die beiden Schenkel verbindende Teil der Nadeln geradlinig ausgestaltet und in engem Abstand parallel zu der Nadelkarte angeordnet ist.

Weitere Einzelheiten der Erfindung ergeben sich aus den Unteransprüchen und der nachfolgenden Beschreibung eines vorteilhaften Ausführungsbeispiels derselben anhand der FIG 1 bis 5, wobei

FIG 1 in schematischer Darstellung die erfindungsgemäße Kontaktiervorrichtung,

FIG 2 eine etwas andere Art der Verbindung der einen Enden der Kontaktiernadeln mit den Zuleitungen zur Prüfeinrichtung,

FIG 3 den Sockel zur Lagerung der Kontaktiernadeln

FIG 4 einen Teil der Kontaktiervorrichtung mit Langloch und

FIG 5 den Schnitt 4-4 zeigt.

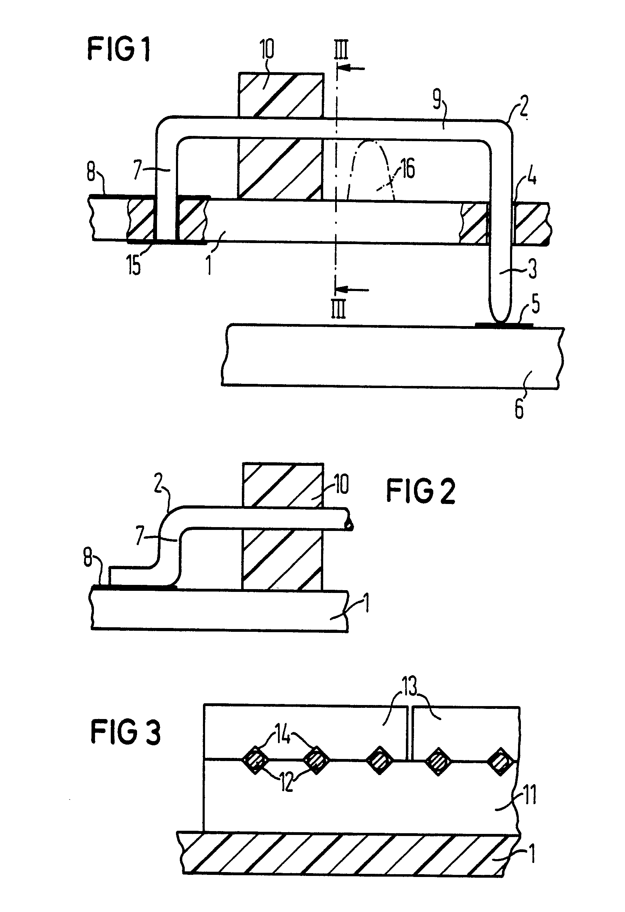

FIG 1 zeigt in schematischer und teilweise geschnittener Darstellung einen Teil einer erfindungsgemäßen Kontaktiervorrichtung, bestehend aus einer Nadelkarte 1, einer Kontaktiernadel 2 und einem auf der Oberseite der Nadelkarte 1 angebrachten Sockel 10. Wie aus der FIG 1 ersichtlich, ist die Kotnaktiernadel 2 U-förmig ausgestal tet und so angeordnet, daß der eine Schenkel der Nadel 2, nämlich der Schenkel 3 durch ein engtoleriertes Führungsloch 4 in der Nadelkarte 1 senkrecht nach unten ragt und mit seiner Spitze federnd auf den Kontaktfleck 5 des zu prüfenden Bauelementes 6 drückt. Der andere Schenkel 7 der Nadel 2 ist mit der zugeordneten Zuleitung 8 zur Prüfungseinrichtung verbunden. Im Falle des Beispiels von FIG 1 ist der Schenkel 7 in eine durchkontaktierte Bohrung 15 in der Nadelkarte 1 eingelötet. Wie in FIG 2 dargestellt, ist es aber auch möglich, den Schenkel 7 der Nadel 2 abzubiegen und unmittelbar mit der Zuleitung 8 zur Prüfungseinrichtung zu verbinden.

Wie aus FIG 1 weiter ersichtlich ist, ist der die beiden Schenkel 3 und 7 der Nadel 2 verbindende Teil 9 geradlinig ausgestaltet und in engem Abstand, z.B. parallel zu Nadelkarte 1 angeordnet. Dies hat den großen Vorteil, daß sich alle Teile der Nadel 2 in unmittelbarer Nähe der Nadelkarte 1 befinden, kurz sind und die Zuleitung 8 von der Nadel 2 zur Prüfeinrichtung im wesentlichen in der Ebene der Nadelkarte 1 liegen kann.

Aus FIG 1 und insbesondere aus FIG 3 ist ersichtlich, daß bei dem dargestellten Ausführungsbeispiel die die Schenkel verbindenden Teile 9 aller Nadeln 2 in einem auf der Oberseite der Nadelkarte 1 angebrachten Sockel 10 gelagert sind. Besonders vorteilhaft ist es, diesen Sokkel 10 zweiteilig auszubilden, wobei mindestens der Unterteil 11 mit Kerben 12 versehen ist, in denen die die Schenkel verbindenden Teile 9 der Nadeln gelagert und festgehalten werden. Eine besonders sichere Halterung und Lagerung dieser Teile der Nadeln 2 erhält man, wenn entsprechende Kerben 14 auch in dem Oberteil 13 des Sockels vorgesehen werden.

Durch Anordnen z.B. eines Klotzes 16 unter den Nadeln 2 können die in dem Sockel 10 gehalterten Nadeln 2 vorgespannt werden.

Durch die Lagerung der Nadeln 2 in einem derart ausgestalteten Sockel 10 ist es möglich, bei Beschädigung einzelner Nadeln oder Gruppen von Nadeln diese durch Abheben des entsprechenden Oberteils 13 des Sockels zu entfernen und durch neue Nadeln zu ersetzen.

Ferner ist es durch die Ausgestaltung und Anordnung der einzelnen Teile der erfindungsgemäßen Kontaktiervorrichtung möglich, alle Teile hochpräzise und weitgehend mechanisiert herzustellen und durch einfaches Einlegen der Nadeln in die Kerben 12 bzw. 14 des Sockels 10 einfach, - schnell und präzise zu justieren. Außerdem ist die erfindungsgemäße Kontaktiervorrichtung wegen des wesentlich geringeren Zeitaufwandes bei der Herstellung und Reparatur wesentlich kostengünstiger.

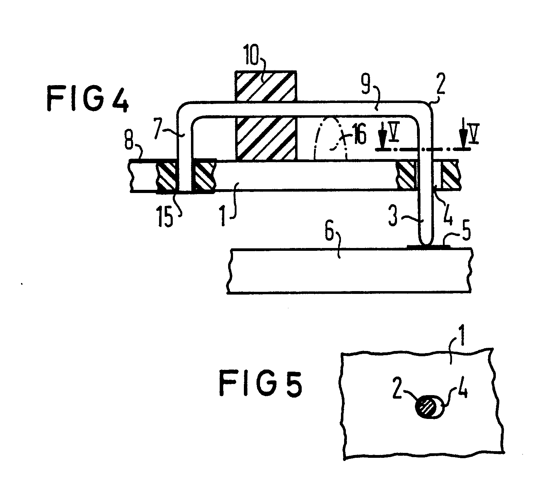

FIG 4 ziegt die gleiche Anordnung wie FIG 1. Lediglich das Führungsloch ist als Langloch ausgebildet, wie aus der FIG 5, die den Schnitt IV-IV zeigt, entnehmbar ist.

## Ansprüche

1. Kontaktiervorrichtung für zu prüfende hochpolige Bauelemente der Mikroelektronik, insbesondere hochintegrierte Schaltkreise, in Form einer sogenannten Nadelkarte mit einer der Anzahl der Kontakte des zur prüfenden Bauelements entsprechenden Anzahl von Kontaktiernadeln, **dadurch gekennzeichnet,** daß die Kontaktiernadeln (2) U-förmig ausgestaltet und so angeordnet sind, daß jeweils der eine (3) der beiden Schenkel der Nadeln (2) durch ein engtoleriertes Führungsloch (4) in der Nadelkarte (1) senkrecht nach unten ragt und seine Spitze federnd auf den Kontaktfleck (5) des zu prüfenden Bauelements (6) drückt, daß der jeweils andere Schenkel (7) der Nadeln (2) mit den Zuleitungen (8) zur Prüfeinrichtung verbunden ist und daß der die beiden Schenkel verbindende Teil (9) der Nadeln (2) geradlinig ausgestaltet und in engem Abstand zu der Nadelkarte (1) angeordnet ist.

2. Kontaktiervorrichtung nach Anspruch 1, **dadurch gekennzeichnet,** daß die die Schenkel verbindenden Teile (9) der Nadeln (2) in einem auf der Oberseite der Nadelkarte (1) angebrachten Sockel (10) gelagert sind.

3. Kontaktierungsvorrichtung nach Anspruch 2, **dadurch gekennzeichnet,** daß der Sockel (10) aus einem auf der Nadelkarte (1) fest angeordnetem, mit Kerben (12) versehenen Unterteil (11) und mindestens einem der Abdeckung dienenden, vorzugsweise mit entsprechend angeordneten Kerben (14) versehenen Oberteil (13) besteht.

4. Kontaktiervorrichtung nach einem der vorhergehenden Ansprüche, **dadurch gekennzeichnet,** daß das Führungsloch als Rundloch ausgebildet ist.

5. Kontaktiervorrichtung nach einem der Ansprüche 1 bis 3, **dadurch gekennzeichnet,** daß das Führungsloch als Langloch ausgebildet ist.

**FIG 1**

10  III  9  2

8  7  16  4

15  1  3

5

6

**FIG 2**

2  10

7

8  1

**FIG 3**

13

14

12  11

1

FIG 4

FIG 5